# EUROPEAN PATENT APPLICATION

(11) **EP 4 191 672 A1**
(43) Date of publication of application: **07.06.2023**
(21) Application number: 21853389.1
(22) Date of filing: 15.06.2021
(51) Int. Cl.: H01L 27/108

(54) **SEMICONDUCTOR STRUCTURE AND METHOD FOR FORMING SEMICONDUCTOR STRUCTURE**

(30) Priority: 03.08.2020 CN 202010767243
(71) Applicant: Changxin Memory Technologies, Inc., Hefei, Anhui 230000 (CN)
(72) Inventor: XU, Yachao, Hefei, Anhui 230000 (CN)
(74) Representative: V.O.
(86) International application number: PCT/CN2021/100088
(87) International publication number: WO 2022/028117

(57) **Abstract**

Provided by the present disclosure are a semiconductor structure and a method for forming the semiconductor structure. The semiconductor structure comprises: a substrate; an active region located in the substrate; and a gate trench that intersects the active region and divides the active region into at least one source region and two drain regions, wherein the source region comprises a first doped region and a first extended doped region below the first doped region.

## Description

### CROSS-REFERENCE TO RELATED APPLICATION

The present application is based upon and claims priority to Chinese Patent Application No. 202010767243.3, filed on August 3, 2020, entitled "Semiconductor Structure and Forming Method of Semiconductor Structure", the disclosure of which is hereby incorporated by reference in its entirety.

### TECHNICAL FIELD

Embodiments of the present application relate to the field of semiconductor manufacturing, and in particular to a semiconductor structure and a forming method of a semiconductor structure.

### BACKGROUND

In a conventional Dynamic Random Access Memory (DRAM) layout, an active region includes two transistors, and two word lines control the two transistors respectively. However, as the size of a DRAM is shrunken, the distance between the two word lines is shortened. When one of the word lines in the same active region is operated, the adjacent word line is inevitably affected and even turned on, i.e., word line-to-word line interference errors occur. Therefore, it is necessary to improve a process technology to improve the problem of word line-to-word line interference.

### SUMMARY

Embodiments of the present application provide a semiconductor structure and a forming method of a semiconductor structure, which can improve the problem of word line-to-word line interference.

In order to solve the above-described technical problem, a semiconductor structure is provided hereinafter. The semiconductor structure includes: a substrate; an active region, located in the substrate; and gate trenches, intersected with the active region and dividing the active region into at least one source region and two drain regions. The source region includes a first doped region and a first extended doped region below the first doped region.

In one embodiment, a side face of the first extended doped region may be not in contact with a side face of the gate trench, and a lateral dimension of the first extended doped region may be smaller than a lateral dimension of the first doped region.

In one embodiment, the first extended doped region may be located below a middle portion of the first doped region.

In one embodiment, the lateral dimension of the first extended doped region may be smaller than 1/3 of the lateral dimension of the first doped region.

In one embodiment, the first doped region and the first extended doped region may be both axisymmetric structures, and axes of symmetry of the first doped region and the first extended doped region may coincide with each other.

In one embodiment, a depth of the first extended doped region in the substrate may be greater than a depth of the gate trench in the substrate.

In one embodiment, a second doped region may be included. The second doped region may be a region in the active region excluding the source region and the drain regions, and may be doped with second-type ions. The first doped region and the first extended doped region may be doped with first-type ions. The first-type ions may be different from the second-type ions.

In one embodiment, the first-type ions may include one of P-type ions and N-type ions, and the second-type ions may include the other of P-type ions or N-type ions.

In one embodiment, the drain region may include a third doped region and a second extended doped region below the third doped region.

In one embodiment, a word line, located in the gate trench, may be included.

In order to solve the above-described technical problem, a forming method of a semiconductor structure is also provided hereinafter. The forming method includes: providing a substrate; forming isolation structures in the substrate to define an active region; forming at least two gate trenches crossing the active region; and forming a first doped region and a first extended doped region below the first doped region in the active region between the gate trenches.

In one embodiment, the step of forming a first doped region and a first extended doped region below the first doped region in the active region between the gate trenches may include: forming a mask layer having openings on the substrate, the opening being located above the active region between the gate trenches; implanting first-type ions into the active region through the opening, to form the first doped region; forming a side wall layer on a side wall of the opening; and implanting first-type ions into the active region through the opening having the side wall layer, to form the first extended doped region.

In one embodiment, a thickness of the side wall layer may be not smaller than 1/3 of a dimension of the opening.

In one embodiment, a depth of the first extended doped region in the substrate may be greater than a depth of the gate trench in the substrate.

In one embodiment, after forming isolation structures in the substrate to define an active region, the method may further include: doping the active region with second-type ions. The second-type ions may be different from the first-type ions.

In one embodiment, the first-type ions may include one of P-type ions and N-type ions, and the second-type ions may include the other of P-type ions or N-type ions.

In one embodiment, the method may further include: forming a second doped region and a second extended doped region located below the second doped region in the active region outside the gate trench.

In one embodiment, a word line may be formed in the gate trench.

According to the semiconductor structure and the forming method thereof in the embodiments of the present application, a first extended doped region is formed between two adjacent word lines, so that the mutual influence between the two word lines is completely cut off, word line-word line disturbance errors caused by too short distance between the two adjacent word lines are effectively prevented, and the performance of the semiconductor structure is improved.

### BRIEF DESCRIPTION OF THEDRAWINGS

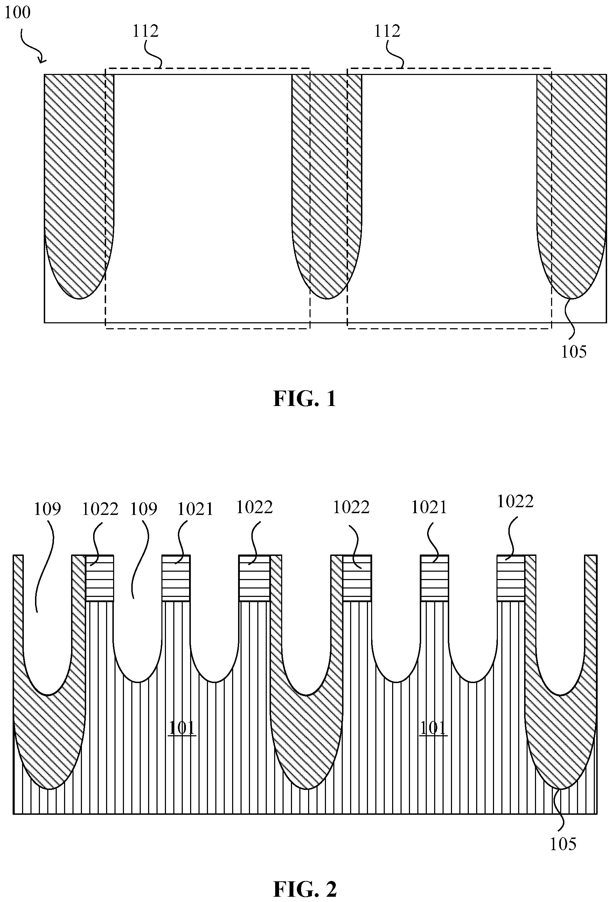

FIGS. 1-7 are cross-sectional diagrams of a semiconductor structure corresponding to steps of a forming method of a semiconductor structure in one embodiment of the present application.

### DETAILED DESCRIPTION

In order to make the above objects, features, and advantages of the embodiments of the present application more apparent and readily understood, the embodiments of the present application will now be described in detail with reference to the accompanying drawings.

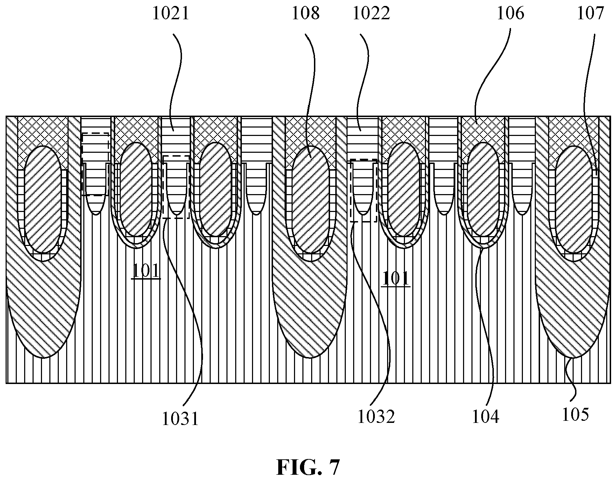

A reference is made to FIGS. 1 and 7. In the present embodiment, a semiconductor structure is provided. The semiconductor structure includes: a substrate 100; an active region 112, located in the substrate 100; and gate trenches 109, intersected with the active region 112 and dividing the active region into at least one source region and two drain regions. The source region includes a first doped region 1021 and a first extended doped region 1031 below the first doped region 1021. In an embodiment, the substrate 100 may be a silicon substrate, a Silicon-On-Insulator (SOI) substrate, or a semiconductor substrate such as gallium nitride or gallium arsenide.

Referring to FIG. 7, in the present embodiment, when a distance between two word lines respectively formed in the two gate trenches is too short, the first extended doped region 1031 can effectively prevent a disturbance error between the two adjacent word lines and improve the reliability of a memory structure formed based on the semiconductor structure.

In the embodiment shown in FIGS. 1-7, two adjacent active regions 112 are spaced apart from each other by an isolation structure 105. The isolation structure 105 is filled with an insulating medium. At least two gate trenches 109 are arranged in the same active region 112. In one embodiment, two adjacent gate trenches 109 are arranged in parallel.

In one embodiment, during the formation of a word line in the gate trench 109, a gate dielectric layer 104 is formed in the gate trench 109 first and then the word line is formed on an upper surface of the gate dielectric layer 104.

In an embodiment, the gate dielectric layer 104 includes a silicon dioxide layer. The word line 113 includes a conductive metal layer, and the conductive metal layer includes a first conductive metal layer 107 and a second conductive metal layer 108. The first conductive metal layer 107 includes a titanium nitride layer, and the second conductive metal layer 108 includes a tungsten layer. Further, a top cover 106 is formed in the gate trench 109. The top cover 106 is formed over the word line, and has an upper surface being flush with an upper surface of the substrate 100. The material of the top cover 106 may be silicon nitride, silicon oxide, etc.

In one embodiment, the first doped region 1021 is made after the word line is formed. In other embodiments, the first doped region 1021 may be formed before the word line or even the isolation trench 105 is made.

In one embodiment, two transistors are formed in an active region 112 such that two gate trenches 109 are formed in the active region 112, and word lines are formed in both the two gate trenches 109 for controlling the enabling conditions of the two transistors, respectively. The first doped region 1021 is arranged between the two gate trenches 109. Since the two gate trenches 109 are formed in the same active region 112, the distance between the two gate trenches 109 is small, and it is needed to form the first extended doped region 1031 between the two gate trenches 109 to completely cut off the disturbance between the two word lines.

In the embodiment shown in FIGS. 1-7, the first doped region 1021 is located in an upper half of the substrate 100 and has an upper surface coinciding with the upper surface of the substrate 100. The first extended doped region 1031 is located below the first doped region 1021, is intersected with a lower surface of the first doped region 1021, and extends from the lower surface of the first doped region 1021 in a direction away from the upper surface of the substrate 100.

In one embodiment, a side face of the first extended doped region 1031 is not in contact with a side face of the gate trench 109, and a lateral dimension of the first extended doped region 1031 is smaller than that of the first doped region 1021. The fact that the side face of the first extended doped region 1031 is not in contact with the side face of the gate trench 109 will not affect an original channel length of the transistor. Thus, the short channel benefit caused by the fact that the original channel length of the transistor is shortened when the side face of the first extended doped region 1031 is in contact with that of the gate trench 109 is prevented.

In one embodiment, the first extended doped region 1031 is located below a middle portion of the first doped region 1021. In practice, the position of the first extended doped region 1031 may also be set as required. When the first extended doped region 1031 is located below the middle portion of the first doped region 1021, the influence on the two transistors in the active region 112 can be balanced, so that the electrical characteristics of the two transistors in the active region 112 are the same, and the device performance is improved.

In one embodiment, a lateral dimension of the first extended doped region 1031 is smaller than 1/3 of a lateral dimension of the first doped region 1021, so as to prevent the first extended doped region 1031 from oversizing to come into contact with the side face of the gate trench 109. By means of the arrangement, a boundary of the first extended doped region 1031 is maintained at a sufficient distance from the gate trench 109, to avoid affecting a channel region of the transistor and resulting in degradation of the device performance.

In one embodiment, the first doped region 1021 and the first extended doped region 1031 are both axisymmetric structures, and axes of symmetry of the first doped region 1021 and the first extended doped region 1031 coincide with each other. This may include each of left and right sides of the first extended doped region 1031 not contacting the side face of the gate trench 109. By means of the arrangement, the influence on the two transistors in the active region 112 can be balanced, so that the electrical characteristics of the two transistors in the active region 112 are the same, and the device performance is improved. Meanwhile, the manufacturing process difficulty of the first doped region 1021 and the first extended doped region 1031 can be reduced, and the cost can be saved.

In one embodiment, a depth of the first extended doped region 1031 in the substrate 100 is greater than a depth of the gate trench 109 in the substrate 100. In this way, an improved effect of interference between word lines formed in the two adjacent gate trenches 109 can be enhanced.

In one embodiment, the drain region includes a third doped region 1022 and a second extended doped region 1032 below the third doped region 1022, referring to FIG. 7 herein. In the present embodiment, there is a common source electrode between the two gate trenches, the third doped region 1022 is arranged between a gate trench and the isolation structure 105, and the second extended doped region 1032 may be configured to isolate the gate trench from the word line in the isolation structure 105. The word line interference between different active regions is further improved by the second extended doped region 1032 below the third doped region 1022.

In one embodiment, a side face of the second extended doped region 1032 is not in contact with a side face of the gate trench 109, and a lateral dimension of the second extended doped region 1032 is smaller than that a lateral dimension the third doped region 1022, thereby avoiding length shrinkage of the transistor channel, which results in short channel effect.

In one embodiment, the second extended doped region 1032 is located below a middle portion of the third doped region 1022. In practice, the position of the second extended doped region 1032 may also be set as required.

In one embodiment, a lateral dimension of the second extended doped region 1032 is smaller than 1/3 of a lateral dimension of the third doped region 1022, so as to prevent the second extended doped region 1032 from oversizing, thereby affecting the channel region of the transistor and resulting in degradation of the device performance.

In one embodiment, the third doped region 1022 and the second extended doped region 1032 are both axisymmetric structures, and axes of symmetry of the third doped region 1022 and the second extended doped region 1032 coincide with each other. Therefore, it can be ensured that both the left and right sides of the second extended doped region 1032 are not in contact with the side faces of the gate trench 109 and the isolation structure 105. Meanwhile, the manufacturing process difficulty of the first doped region 1021 and the first extended doped region 1031 can be reduced, and the cost can be saved.

In one embodiment, a depth of the second extended doped region 1032 in the substrate 100 is greater than a depth of the gate trench 109 in the substrate 100. In this way, an improved effect of interference between word lines formed in the gate trench 109 and the isolation structure 105 can be enhanced.

In one embodiment, the type of ions doped into the third doped region 1022 is the same as the type of ions doped into the first doped region 1021, both being first-type ions. The type of ions doped into the second extended doped region 1032 is also the same as the type of ions doped into the first doped region 1021, both also being first-type ions.

In one embodiment, a second doped region 101 is further included. The second doped region 101 is a region in the active region 112 excluding the source region and the drain regions. The second doped region 101 is doped with second-type ions.

In the present embodiment, the second-type ions are different from the first-type ions. In one embodiment, the first-type ions include one of P-type ions and N-type ions, and the second-type ions include the other of P-type ions or N-type ions.

In one embodiment, the P-type ions include boron ions and the N-type ions include phosphorus ions.

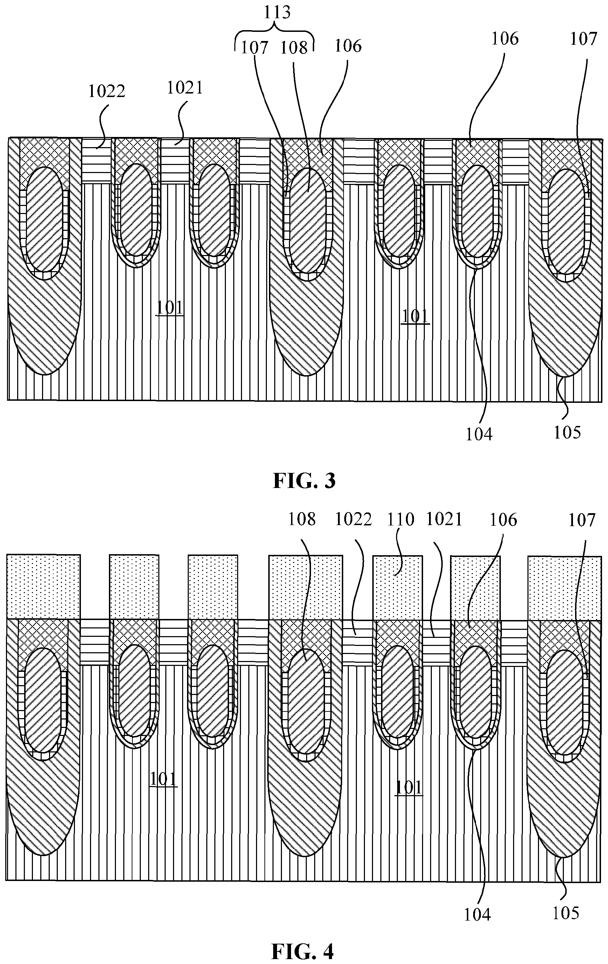

In one embodiment, the first doped region 1021, the third doped region 1022, the first extended doped region 1031, and the second extended doped region 1032 are formed by arranging a mask on the surface of the substrate 100. In one embodiment, the first doped region 1021 and the third doped region 1022 are formed in one step, referring to FIG. 4 herein. A mask layer 110 having openings is formed on the surface of the active region. The openings expose the source and drain regions of the active region. The first doped region 1021 and the third doped region 1022 are formed in the source region and the drain region respectively, by ion implantation.

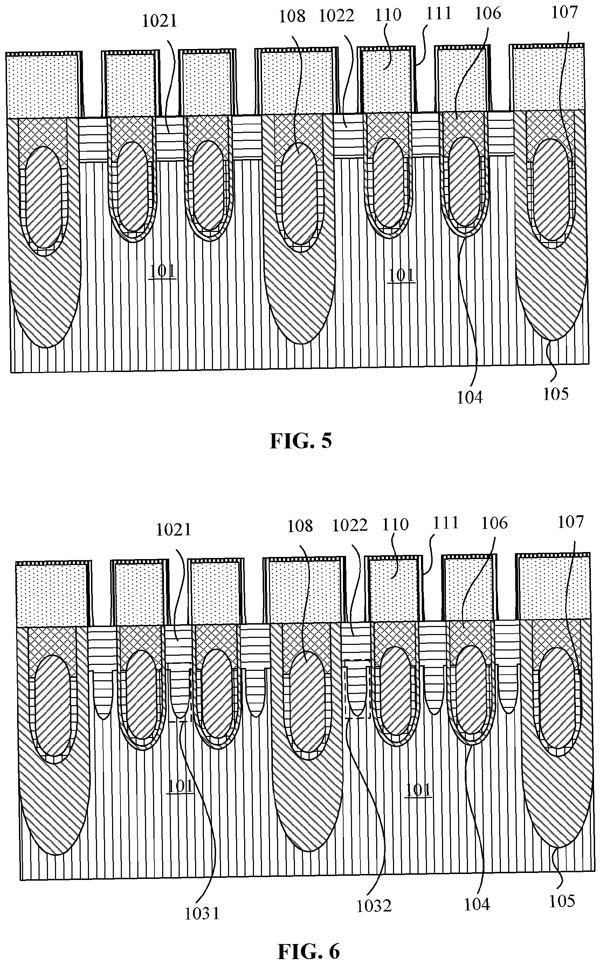

In one embodiment, the first extended doped region 1031 and the second extended doped region 1032 are formed in one step, referring to FIGS. 5 and 6 herein. In the embodiment shown in FIGS. 5 and 6, an ion concentration of the first extended doped region 1031 is the same as an ion concentration of the first doped region 1021, and an ion concentration of the second extended doped region 1032 is the same as an ion concentration of the third doped region 1022.

In practice, it is also possible to set the ion concentration of the first extended doped region 1031 to be different from the ion concentration of the first doped region 1021, and set the ion concentration of the second extended doped region 1032 to be different from the ion concentration of the third doped region 1022, as required.

In the embodiment shown in FIG. 7, the first-type ions are P-type ions and the second-type ions are N-type ions. In other embodiments, the first-type ions may be set to N-type ions and the second-type ions may be set to P-type ions as required.

In the embodiment shown in FIG. 7, the first extended doped region 1031 is provided such that the substrate 100 has an additionally formed PN junction composed of the third doped region 1022 and the first extended doped region 1031 in addition to an original PN junction formed by the first doped region 1021 and the third doped region 1022. In this way, when a first storage unit formed of a first transistor is repeatedly enabled, an electromagnetic signal generated by a word line of the first storage unit may be blocked by the first extended doped region 1031 without affecting a word line of a second storage unit physically adjacent to the first storage unit, thereby improving the reliability of a memory structure formed based on the semiconductor structure.

A forming method of a semiconductor structure is also provided hereinafter. The forming method includes the following operations. A substrate 100 is provided. Isolation structures 105 are formed in the substrate 100 to define an active region 112. At least two gate trenches 109 crossing the active region 112 are formed. A first doped region 1021 and a first extended doped region 1031 below the first doped region 1021 are formed in the active region between the gate trenches 109.

In the present embodiment, a first doped region 1021 and a first extended doped region 1031 located below the first doped region 1021 are formed in the active region between the gate trenches 109, and the first extended doped region 1031 may be located between two adjacent gate trenches 109 to prevent word line-to-word line interference between two adjacent word lines due to too short distance between two adjacent word lines after word lines are subsequently formed in the gate trenches 109.

In one embodiment, the step that the first doped region 1021 and the first extended doped region 1031 below the first doped region 1021 are formed in the active region 112 between the gate trenches 109 includes the following operations. A mask layer 110 having openings is formed on the substrate 100. The opening is located above the active region 112 between the gate trenches 109. First-type ions are implanted into the active region 112 through the opening to form the first doped region 1021. The first doped region 1021 has an axisymmetric structure. A side wall layer 111 is formed on a side wall of the opening. First-type ions are implanted into the active region 112 through the opening having the side wall layer 111 to form the first extended doped region 1031. In an embodiment, a conformal layer may be formed at a bottom and the side wall of the opening using an atomic layer deposition process. The conformal layer may be a silicon oxide layer, a silicon nitride layer, etc. The side wall layer 111 may be formed by removing the conformal layer at the bottom of the opening using a dry etching process. The side wall layer 111 has the same thickness throughout the side wall of the opening. The first extended doped region 1031 formed by implanting first-type ions into the active region 112 through the opening having the side wall layer 111 has an axisymmetric structure, and axes of symmetry of the first doped region 1021 and the first extended doped region 1031 coincide with each other. The first extended doped region 1031 formed in this manner has low process difficulty and low cost.

In one embodiment, a thickness of the side wall layer 111 is not smaller than 1/3 of a dimension of the opening. In this way, a lateral dimension of the first extended doped region 1031 finally formed is smaller than one third of a lateral dimension of the first doped region 1021.

In one embodiment, a depth of the first extended doped region 1031 in the substrate 100 is greater than a depth of the gate trench 109 in the substrate 100. In this way, an improved effect of interference between word lines formed in the two adjacent gate trenches 109 can be enhanced.

In one embodiment, after forming isolation structures 105 in the substrate 100 to define an active region 112, the method further includes the following operation. The active region 112 is doped with second-type ions. The second-type ions are different from the first-type ions.

In one embodiment, the first-type ions include one of P-type ions and N-type ions, and the second-type ions include the other of P-type ions or N-type ions.

In one embodiment, the method further includes the following operation. A second doped region 1022 and a second extended doped region 1032 located below the second doped region 1022 are formed in the active region 112 outside the gate trenches 109.

Although the embodiments of the present application have been disclosed in terms of exemplary embodiments, the exemplary embodiments are not intended to limit the embodiments of the present application. Anyone of ordinary skill in the art, without departing from the spirit and scope of the embodiments of the present application, may make possible variations and modifications to the technical solutions of the embodiments of the present application according to the methods and technical solutions disclosed above. Therefore, any simple modifications, equivalent variations and modifications made on the above-described embodiments according to the technical essence of the embodiments of the present application, without departing from the content of the technical solutions of the embodiments of the present application, fall within the scope of protection of the technical solutions of the embodiments of the present application.

## Claims

1. A semiconductor structure, comprising:
a substrate;
an active region, located in the substrate; and
gate trenches, intersected with the active region and dividing the active region into at least one source region and two drain regions, the source region comprising a first doped region and a first extended doped region below the first doped region.

2. The semiconductor structure of claim 1, wherein a side face of the first extended doped region is not in contact with a side face of the gate trench, and a lateral dimension of the first extended doped region is smaller than a lateral dimension of the first doped region.

3. The semiconductor structure of claim 2, wherein the first extended doped region is located below a middle portion of the first doped region.

4. The semiconductor structure of claim 3, wherein the lateral dimension of the first extended doped region is smaller than 1/3 of the lateral dimension of the first doped region.

5. The semiconductor structure of claim 4, wherein the first doped region and the first extended doped region are both axisymmetric structures, and axes of symmetry of the first doped region and the first extended doped region coincide with each other.

6. The semiconductor structure of claim 2, wherein a depth of the first extended doped region in the substrate is greater than a depth of the gate trench in the substrate.

7. The semiconductor structure of claim 1, further comprising:
a second doped region, the second doped region being a region in the active region excluding the source region and the drain regions, and being doped with second-type ions,
wherein the first doped region and the first extended doped region are doped with first-type ions; and
the first-type ions are different from the second-type ions.

8. The semiconductor structure of claim 7, wherein the first-type ions comprise one of P-type ions and N-type ions, and the second-type ions comprise the other of P-type ions or N-type ions.

9. The semiconductor structure of any one of claims 1-8, wherein the drain region comprises a third doped region and a second extended doped region below the third doped region.

10. The semiconductor structure of claim 9, further comprising:
a word line, located in the gate trench.

11. A forming method of a semiconductor structure, comprising:
providing a substrate;
forming isolation structures in the substrate to define an active region;
forming at least two gate trenches crossing the active region; and
forming a first doped region and a first extended doped region below the first doped region in the active region between the gate trenches.

12. The forming method of a semiconductor structure of claim 11, wherein the step of forming a first doped region and a first extended doped region below the first doped region in the active region between the gate trenches comprises:
forming a mask layer having openings on the substrate, the opening being located above the active region between the gate trenches;
implanting first-type ions into the active region through the opening to form the first doped region;
forming a side wall layer on a side wall of the opening; and
implanting first-type ions into the active region through the opening having the side wall layer, to form the first extended doped region.

13. The forming method of a semiconductor structure of claim 12, wherein a thickness of the side wall layer is not smaller than 1/3 of a dimension of the opening.

14. The forming method of a semiconductor structure of claim 12, wherein a depth of the first extended doped region in the substrate is greater than a depth of the gate trench in the substrate.

15. The forming method of a semiconductor structure of claim 12, after forming the isolation structures in the substrate to define the active region, further comprising:
doping the active region with second-type ions, wherein the second-type ions are different from the first-type ions.

16. The forming method of a semiconductor structure of claim 15, wherein the first-type ions comprise one of P-type ions and N-type ions, and the second-type ions comprise the other of P-type ions or N-type ions.

17. The forming method of a semiconductor structure of any one of claims 11-16, further comprising:
forming a second doped region and a second extended doped region located below the second doped region in the active region outside the gate trench.

18. The forming method of a semiconductor structure of claim 17, further comprising:
forming a word line in the gate trench.

19. The forming method of a semiconductor structure of claim 11, further comprising:
arranging two adjacent gate trenches in parallel.

20. The forming method of a semiconductor structure of claim 18, further comprising:
forming a top cover in the gate trench, the top cover being formed above the word line.
